## Europäisches Patentamt
## European Patent Office
## Office européen des brevets

(19)

(11) Numéro de publication : **0 141 704 B1**

(12)

# FASCICULE DE BREVET EUROPÉEN

(45) Date de publication du fascicule du brevet :
04.05.88

(21) Numéro de dépôt : 84401894.5

(22) Date de dépôt : 21.09.84

(51) Int. Cl.⁴ : **H 03 H   1/00, H 01 G   4/34**

(54) **Filtre miniature hyperfréquence à résonateurs, constitués par des circuits bouchons, couplés par des condensateurs.**

(30) Priorité : 27.09.83 FR 8315335

(43) Date de publication de la demande :
15.05.85 Bulletin 85/20

(45) Mention de la délivrance du brevet :
04.05.88 Bulletin 88/18

(84) Etats contractants désignés :
DE GB IT

(56) Documents cités :
FR-A- 1 496 638
GB-A- 1 180 928
US-A- 3 755 762
US-A- 4 074 340

(73) Titulaire : ALCATEL ESPACE
11, avenue Dubonnet
F-92407 Courbevoie Cédex (FR)

(72) Inventeur : Milard, Roland
THOMSON-CSF SCPI 173, bld Haussmann
F-75379 Paris Cedex 08 (FR)

(74) Mandataire : Weinmiller, Jürgen et al
Lennéstrasse 9 Postfach 24
D-8133 Feldafing (DE)

EP 0 141 704 B1

## Description

Les filtres hyperfréquences passe-bande ou coupe-bande constitués par des résonateurs à circuits bouchons couplés entre eux au moyen de condensateurs sont bien connus. Leur réalisation, en vue de leur utilisation dans le domaine des hyperfréquences est cependant délicate car à ces fréquences les condensateurs d'accord des circuits résonnants et les condensateurs de couplage des résonateurs ont des capacités très faibles, difficilement mesurables et ajustables.

La réalisation par exemple, de filtres travaillant sur des fréquences de quelques centaines de MHz conduit à des valeurs de condensateurs de quelques dizaines de picofarads pour les condensateurs d'accord et de quelques picofarads pour des condensateurs de liaison. On conçoit dès lors que ces conditions ne sont pas favorables à la fabrication en série de ces types de filtres, leur caractéristique électrique étant difficilement reproductible d'un filtre à l'autre.

Une solution à ces difficultés est souvent apportée en réalisant des résonateurs constitués par des lignes « quart d'onde » court-circuitées à leurs extrémités, réalisées à l'aide des techniques de fabrication des micro-circuits ou encore, en réalisant des filtres en « hélice » constitués aussi par des lignes quart d'onde, court-circuitées à leurs extrémités, enroulées autour d'un mandrin, les couplages entre résonateurs de ces deux types de filtres étant obtenus par induction mutuelle entre résonateurs.

Ces filtres ont cependant pour inconvénient de conduire à des réalisations volumineuses et d'être, par conséquent, mal adaptés à certaines applications particulières exigeant des réalisations de faible volume et de faible poids comme ceci est exigé, par exemple, pour tous les constituants entrant dans la fabrication des satellites de télécommunications.

Le but de l'invention est de pallier les inconvénients précités.

Une solution est donnée dans le document US-A-3 755 762 qui décrit un procédé de fabrication de filtres électriques, utilisés notamment dans des équipements de télécommunications, et formés d'assemblages d'inductances et de condensateurs sur un substrat isolé dans lesquels les inductances qui ont la forme de tores magnétiques utilisent un bloc de ferrite commun formé de deux parties contiguës et dans lesquels les condensateurs sont composés de plaques métalliques parallèles supportées, et séparées par le diélectrique dudit substrat qui est placé en contact avec la surface extérieure de l'une des deux parties contiguës.

En outre le document FR-A-1 496 638 décrit un condensateur formé de couches métalliques parallèles supportées et séparées par un substrat diélectrique et dont la valeur peut être ajustée en ajoutant ou en éliminant des capacités partielles situées à la périphérie des électrodes des capacités principales.

Par contre, l'invention a pour objet, un filtre miniature hyperfréquence à résonateurs constitués par des circuits bouchons, couplés par des condensateurs, les condensateurs d'accord et de couplage étant composés par des plaques métalliques parallèles supportées et séparées par le diélectrique d'un substrat, caractérisé en ce que, la surface d'au moins une plaque de chaque condensateur d'accord et/ou de couplage est ajourée par des fenêtres susceptibles d'être bouchées par un dépôt métallique afin de permettre le réglage de chaque condensateur à sa valeur optimale.

Selon une autre caractéristique du filtre selon l'invention, le couplage entre résonateurs consécutifs est réalisé à l'aide d'au moins deux condensateurs montés en série, pour permettre, en accédant sur le point de liaison commun aux deux condensateurs, la mesure précise de la valeur de chacun des deux condensateurs.

Outre l'extrême miniaturisation rendue possible par la structure du filtre selon l'invention, l'invention a pour avantage qu'elle permet d'obtenir, malgré la faible capacité des condensateurs de couplage et d'accord, un réglage précis des condensateurs en garantissant ainsi une bonne reproductibilité des caractéristiques des filtres fabriqués en série.

D'autres caractéristiques et avantages de l'invention apparaîtront également à l'aide de la description qui va suivre faite au regard des dessins annexés qui représentent :

La figure 1, un schéma de réalisation d'un filtre passe-bande à circuits bouchons couplés par condensateurs.

La figure 2, un schéma de réalisation d'un filtre passe-bande selon l'invention.

La figure 3, un schéma de principe du circuit capacitif mis en œuvre pour la réalisation du filtre hyperfréquence selon l'invention.

La figure 4, un exemple de réalisation d'un micro-circuit réalisé suivant le schéma de principe de la figure 3.

La figure 5, une vue en coupe suivant la coupe V du microcircuit représenté à la figure 4.

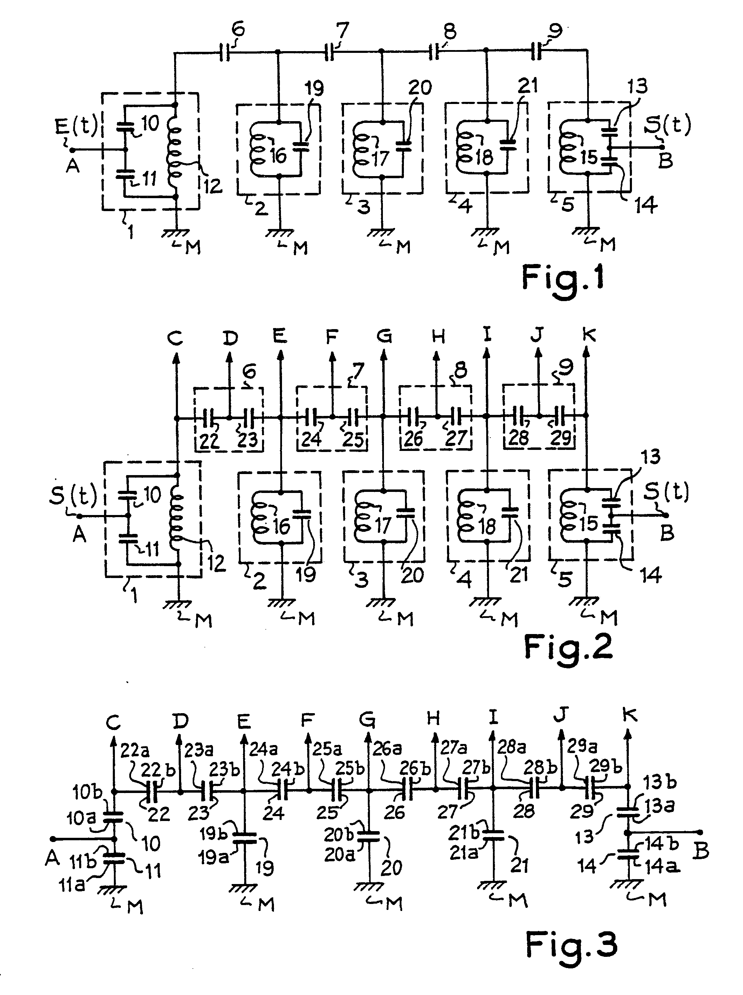

Le schéma représenté à la figure 1 est un schéma de principe d'un filtre hyperfréquence à résonateurs à circuits bouchons du type de ceux pour lesquels la présente invention est applicable. Il comprend une entrée A du signal E(t) à filtrer et une sortie B du signal filtré S(t), les signaux S(t) et E(t) étant liés la relation

$$S(t) = H \times E(t)$$

qui représente le produit de convolution du signal E(t) par la fonction H, H désignant la fonction de transfert du filtre. Il comprend également un ensemble de résonateurs ou circuits bouchons notés respectivement de 1 à 5 à l'intérieur de rectangles en pointillés, ces circuits bouchons étant reliés par une de leurs extrémités à un circuit de masse commun M et couplés entre eux par des condensateurs de couplage référencés de 6 à 9. L'ensemble des circuits bouchons et des condensateurs de couplage est adapté dans chaque cas d'utilisation particulier de manière à réaliser la fonction de transfert H = S(t)/E(t) souhaitée du filtre.

Les circuits bouchons 1 et 5 constituent les éléments résonnants d'entrée-sortie du filtre. L'entrée A du filtre est connectée au point de liaison commun de deux condensateurs 10 et 11 reliés en série. Les extrémités non communes des condensateurs 10 et 11 sont reliées aux extrémités d'une inductance 12 pour former le circuit bouchon d'entrée 1 du filtre. De façon similaire la sortie B du filtre est connectée au point de liaison commun de deux condensateurs 13 et 14 reliés en série. Les extrémités non communes des condensateurs 13 et 14 sont reliées aux extrémités d'une inductance 15 pour former le circuit bouchon de sortie 5 du filtre. Les circuits bouchons intermédiaires 2, 3 et 4 sont constitués respectivement par des inductances, notées respectivement 16, 17 et 18, couplées en parallèle à des condensateurs désignés respectivement par les références 19, 20 et 21.

Comme indiqué précédemment, l'inconvénient majeur qui rend délicate la réalisation des filtres du type de celui représenté à la figure 1 est qu'il est difficile d'obtenir, lorsque ceux-ci sont fabriqués en série, des caractéristiques facilement reproductibles d'un filtre à l'autre.

La difficulté est de deux ordres, elle est d'une part liée à l'extrème petitesse des valeurs des condensateurs de couplage et d'accord des circuits bouchons ce qui entraînent des dispersions sur les valeurs des condensateurs fabriqués, et d'autre part, elle est liée au fait qu'il n'est pas possible d'effectuer une mesure précise des valeurs des condensateurs de couplage, ceux-ci ne pouvant être isolés du reste du circuit du filtre.

Ces difficultés sont résolues grâce a la structure particulière du filtre de l'invention qui est représenté aux figures 2 à 5.

Le schéma de principe du filtre selon l'invention, représenté à la figure 2, est semblable au schéma du filtre représenté à la figure 1, à la différence cependant que les moyens de couplage 6 à 9 qui sont constitués sur la figure 1 par de simples condensateurs, sont constitués sur la figure 2 par des paires de condensateurs notées respectivement 22, 23 ; 24, 25 ; 26, 27 ; 28, 29 ; reliées en série entre respectivement les extrémités marquées C, E, G, I, K, non à la masse M, des circuits bouchons 1, 2, 3, 4 et 5. Du fait de la similitude entre les figures 1 et 2, les éléments identiques sur les deux figures sont repérés sur chacune d'entre elles en utilisant les mêmes références. Sur la figure 2, les points D, F, H et J désignent respectivement les points de liaison commun entre deux condensateurs d'une même paire, des paires de condensateurs notées respectivement 22, 23 ; 24, 25 ; 26, 27 ; 28, 29. Cette disposition a pour avantage, qu'elle permet la mesure précise des condensateurs de couplage, en donnant la possibilité, pour effectuer la mesure, de relier à la masse l'extrémité non à la masse des circuits bouchons, pour isoler chaque condensateur mesuré du reste des autres éléments du filtre. En effet, en court-circuitant à la masse M les extrémités C et E des circuits bouchons 1 et 2, les condensateurs 22 et 23 se trouvent isolés du reste des circuits du filtre et rendent possible, par conséquent, la mesure de la capacité au point D qui résulte de la mise en parallèle des condensateurs 22 et 23. On notera que suivant ce principe, la même mesure pourra être répétée aux points F, H et J.

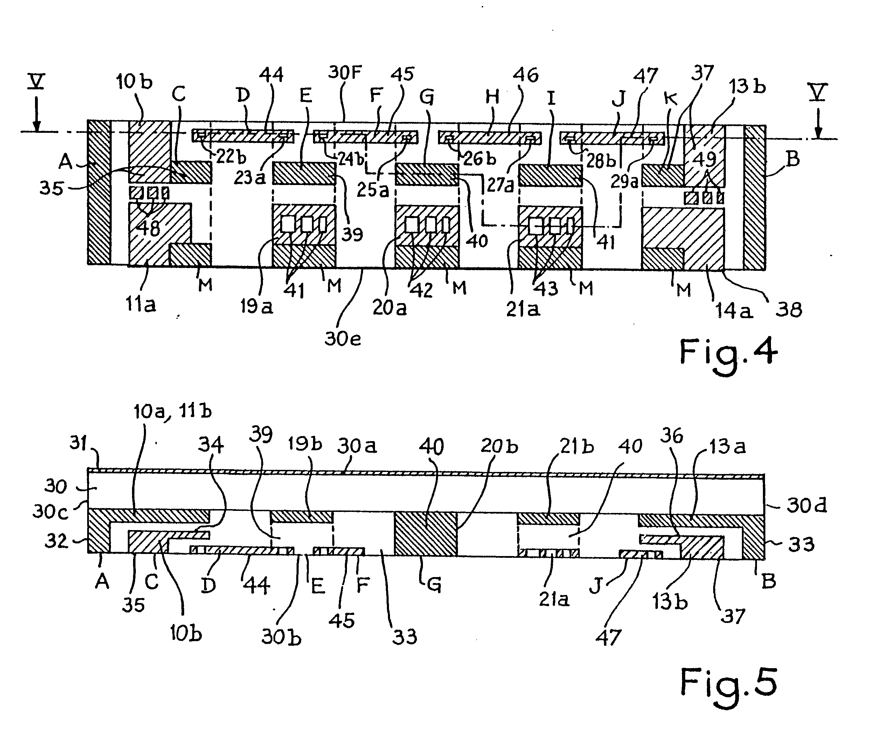

Le schéma de réalisation du circuit capacitif du filtre représenté à la figure 2 est montré à la figure 3. Ce schéma comporte les mêmes éléments que ceux de la figure 2, à la différence toutefois, que les inductances 12, 15, 16, 17 et 18 placées entre les extrémités de connexion C, E, G, I, K des circuits bouchons et la masse M, ne sont pas représentées. Sur cette figure les armatures de chaque condensateur sont repérées en utilisant les mêmes références utilisées pour repérer les condensateurs correspondants de la figure 2 en leur adjoignant les indices a et b. Le micro-circuit capacitif correspondant, représenté aux figures 4 et 5, comprend un substrat 30 composé par deux faces rectangulaires planes $30_a$ et $30_b$, deux faces d'extrémités $30_c$ et $30_d$ disposées dans la largeur du substrat et deux faces longitudinales $30_e$ et $30_f$. Le substrat 30 est constitué par un matériau à permittivité élevée du type titanate de magnésium, alumine ou téflon et son épaisseur entre les deux faces $30_a$ et $30_b$ est de quelques dixièmes de millimètres. La première face $30_a$ supporte une ligne de masse 31. Des plaques métalliques $10_a$, $19_b$, $20_b$, $21_b$ et $13_a$ représentant les armatures des condensateurs 10, 19, 20, 21 et 13 représentées à la figure 3 sont enterrées, isolées par des espaces les unes des autres, dans l'épaisseur du substrat 30, et sont alignées dans cet ordre sur un même plan parallèle à la face $30_a$ du substrat, la plaque 10 étant disposée à l'extrémité gauche, près de la face d'extrémité $30_c$ et la plaque $13_a$ étant disposée à l'extrémité droite, près de la face d'extrémité $30_d$. Les plaques métalliques $10_a$, $19_b$, $20_b$, $21_b$, $13_a$ ont une forme à peu près rectangulaire, les dimensions d'un de leurs côtés étant à peu près égales à la largeur du substrat. La plaque $10_a$ présente un bord relevé 32, faisant saillie sur la plaque et disposé contre la face d'extrémité $30_c$, la hauteur du bord faisant saillie étant suffisante pour permettre au bord relevé 32 de déboucher par son extrémité de la face $30_b$ du substrat, pour former le point A de connexion de l'entrée du filtre. De façon à peu près identique, la plaque $13_a$ présente un bord relevé 33 faisant saillie sur la plaque et disposé de manière à être contre la face d'extrémité $30_d$ du substrat, la hauteur du bord en saillie étant suffisante pour permettre au bord relevé 33 de déboucher par son extrémité de la face $30_b$ du substrat de manière à former le point B de connexion de la sortie du filtre. La plaque métallique $10_b$ formant la deuxième armature du condensateur 10 présente une partie enterrée 34 et une partie en saillie 35 en forme de L sur une de ses faces qui débouche de la face $30_b$ du substrat, une branche du L parallèle à la direction longitudinale du substrat formant le point de connexion C de la figure 3. La plaque métallique $10_b$ a des dimensions à peu près rectangulaires et est disposée en regard et parallèlement a la plaque $10_a$, entre celle-ci et la face supérieure $30_b$ du substrat. Un côté de la plaque $10_b$ est placé contre la face longitudinale $30_f$ et sa longueur est à peu près égale à celle du côté correspondant de la plaque $10_a$ qui lui est parallèle. La longueur du côté adjacent au côté précédent de la plaque $10_b$ est de dimension à peu près égale à la moitié de la largeur du substrat.

De façon à peu près similaire la plaque $13_b$ représentée en pointillés dans l'épaisseur du substrat et formant la deuxième armature du condensateur 13 de la figure 3, présente une partie enterrée 36 une partie en saillie 37 en forme de L qui débouche sur la face $30_b$ du substrat, une branche du L étant parallèle à la direction longitudinale du substrat et formant le point de connexion K représenté à la figure 3. La plaque métallique $13_b$ a des dimensions à peu près rectangulaires et est disposée en regard et parallèlement à la plaque $13_a$, entre celle-ci et la face supérieure $30_b$ du substrat. Un côté de la plaque $13_b$ est placé contre la face longitudinale $30_f$ et sa longueur est à peu près égale à celle du côté correspondant de la plaque $13_a$ qui lui est parallèle.

Les plaques métalliques $19_b$, $20_b$, $21_b$ sont disposées entre les plaques $10_a$ et $13_a$ et présentent également des parties en saillie qui sont disposées cette fois à peu près en leur milieu, notées respectivement 39, 40 et 41 et qui viennent crever la surface $30_b$ du substrat, pour former les points de liaison E, G, I, de la figure 3.

Des plaques métalliques espacées, référencées $11_a$, $19_a$, $20_a$, $21_a$ et $14_a$, correspondant aux armatures reliées à la masse M des condensateurs 11, 19, 20, 21 et 14 représentés à la figure 3, sont placées au-dessus de la face $30_b$ du substrat en regard et parallèlement respectivement aux plaques $10_a$, $19_b$, $20_b$, $21_b$ et $13_a$. Elles ont des formes à peu près rectangulaires et sont reliées à la ligne de masse 31 par un de leurs côtés au travers d'une bande métallisée 38 qui recouvre la face longitudinale $30_a$ du substrat. Elles sont également disposées de manière à être en regard des parties en saillie 35, 39, 40, 41 et 37 entre ces dernières et la bande métallisée 38, le côté opposé au côté en contact avec la bande métallisée 38 étant distant de la partie en saillie correspondante, de manière à assurer l'isolement entre chaque plaque et la partie en saillie correspondante.

Les plaques $19_a$, $20_a$, $21_a$ sont ajourées par des fenêtres 41, 42, 43, de surfaces variables, susceptibles d'être bouchées par une métallisation pour permettre l'ajustement des valeurs des condensateurs 19, 20 et 21 correspondants de la figure 3, en modifiant à volonté la surface des plaques $19_a$, $20_a$ et $21_a$.

Dans un mode préféré de réalisation de l'invention les surfaces des fenêtres sur une plaque seront toutes différentes et seront par exemple proportionnées à la manière des poids dans une boîte de poids pour faciliter l'ajustement précis des condensateurs.

Des bandes métalliques 44 à 47 sont placées sur la face $30_b$ du substrat, dans la direction longitudinale de celui-ci, au-dessus des intervalles compris entre les plaques enterrées $10_b$, $19_b$, $20_b$, $21_b$ et $13_b$, la longueur de chacune des bandes étant suffisante pour que ces extrémités viennent chevaucher chacune des deux plaques enterrées délimitant l'intervalle au-dessus duquel elle est située, de manière à former les condensateurs de liaison notés respectivement de 22 à 29 sur la figure 3.

Les extrémités des bandes métalliques 44 à 47 sont percées également chacune d'au moins une fenêtre notée respectivement $22_b$, $23_a$, $24_b$, $25_a$, $26_b$, $27_a$, $28_b$ et $29_a$ pour permettre éventuellement un rebouchage de chacune de celle-ci pour ajuster les capacités des condensateurs de couplage 22 à 29.

Egalement, des pastilles métalliques 48 et 49 sont placées au-dessus de la surface $30_b$ du substrat, à environ la moitié de la largeur du substrat, entre respectivement les extrémités des plaques $10_b$ et $11_a$ d'une part, et $13_b$ et $14_a$ d'autre part, pour pouvoir, en tant que de besoin, être reliée chacune par un dépôt métallique sur l'une ou l'autre des extrémités des plaques en face desquelles elles sont en regard, pour augmenter artificiellement la surface de l'une ou l'autre plaque, permettant ainsi d'ajuster à volonté la valeur des condensateurs d'entrée et de sortie 10, 11, 13 et 14.

La structure du filtre hyperfréquence selon l'invention qui vient d'être décrite, permet avantageusement un réglage et une mise au point des condensateurs d'accord des circuits résonnants et des condensateurs de couplage reliant chacun des résonateurs. L'accessibilité des points de liaison C, D, E, F, G, H, I, J, K du circuit capacitif obtenu grâce aux parties en saillie des plaques enterrées et aux bandes de liaison 44 à 47 autorisent en effet de court-circuiter à volonté chacun des condensateurs d'accord pour permettre la mesure précise du condensateur de couplage placés de part et d'autre des bandes métalliques des liaisons 44 à 47. Cette facilité de mesure est complétée par les facilités de réglage de chacun des condensateurs d'accord et de couplage par rebouchage des fenêtres 41, 42 et 43. Ce réglage pouvant être obtenu directement par la mesure de la capacité d'un condensateur de liaison qui permet à partir du modèle mathématique du filtre, de déterminer par le calcul les valeurs qui doivent être données aux autres condensateurs. Connaissant ces valeurs, il est dès lors possible, à partir des facilités de réglage qui viennent d'être décrites, de régler la valeur des capacités du filtre à leurs valeurs optimums.

L'exemple qui vient d'être donné d'une réalisation préférée de l'invention n'est pas limité au filtre précédemment décrit, il va de soi que l'invention s'applique également à d'autres variantes de réalisation, pouvant être empruntées notamment aux techniques de fabrication des micro-circuits à couche mince ou épaisse par voie sérigraphique ou encore par photogravure.

On comprendra également que l'invention n'est pas non plus limitée au nombre de résonateurs utilisés, ni à la structure de ceux-ci qui au lieu d'avoir des structures en parallèle, comme cela a été représenté dans le mode de réalisation de l'invention, peuvent avoir des structures en série, ni au mode de couplage des résonateurs d'entrée et de sortie aux circuits extérieurs au filtre.

**Revendications**

1. Filtre miniature hyperfréquence à résonateurs constitués par des circuits bouchons (1, 2, 3, 4, 5), couplés par des condensateurs (6, 7, 8, 9) les condensateurs d'accord et de couplage étant composés par des plaques métalliques parallèles supportées et séparées par le diélectrique (30) d'un substrat, caractérisé en ce que, la surface d'au moins une plaque (19$_a$, 20$_a$, 44, 45, 46, 47) de chaque condensateur d'accord et/ou de couplage (19, 20, 21 ; 22, 23, 24, 25, 26, 27, 28, 29) est ajourée par des fenêtres (41, 42, 43) susceptibles d'être bouchées par un dépôt métallique afin de permettre le réglage de chaque condensateur à sa valeur optimale.

2. Filtre selon la revendication 1, caractérisé en ce que le couplage entre résonateurs consécutifs est réalisé à l'aide d'au moins deux condensateurs (22, 23 ; 24, 25 ; 26, 27 ; 28, 29) montés en série, pour permettre, en accédant sur le point de liaison (D, F, H, J) commun aux deux condensateurs, la mesure précise de la valeur de chacun des deux condensateurs.

3. Filtre selon l'une quelconque des revendications 1 et 2, caractérisé en ce que les surfaces des fenêtres sur une plaque sont toutes différentes.

4. Filtre selon la revendication 3, caractérisé en ce que les surfaces des fenêtres sur une plaque sont proportionnées à la manière des poids composant une boîte de poids pour faciliter l'ajustement précis des condensateurs (19, 20, 21, 22, 23, 24, 25, 26, 27, 28, 29).

5. Filtre selon l'une quelconque des revendications 1 à 4, caractérisé en ce que des pastilles métalliques (48, 49) sont également disposées à proximité des plaques (10$_b$, 11$_a$, 13$_b$, 14$_a$) des condensateurs d'accord des circuits bouchons d'entrée et de sortie du filtre, pour augmenter à volonté la surface d'une plaque située à proximité des pastilles des valeurs respectives des éléments de surfaces correspondant de ces pastilles.

6. Filtre selon la revendication 5, caractérisé en ce que l'augmentation de la surface d'une plaque (10$_b$, 11$_a$, 13$_b$, 14$_a$) de l'élément de surface d'une pastille (48, 49) est effectuée en reliant la plaque à la pastille par un dépôt métallique.

7. Filtre selon l'une quelconque des revendications 1 à 6, caractérisé en ce que les plaques (19$_a$, 20$_a$, 21$_a$) ajourées par des fenêtres sont disposées sur une surface extérieure (30$_b$) au substrat et que les plaques en regard (19$_b$, 20$_b$, 21$_b$) pour former la deuxième armature de chaque condensateur correspondant sont enterrées dans l'épaisseur du substrat.

8. Filtre selon la revendication 7, caractérisé en ce que les plaques ajourées des fenêtres disposées sur une face du substrat sont reliées à une bande métallisée recouvrant l'autre face du substrat par l'intermédiaire d'une bande métallisée (38) recouvrant une face longitudinale (30$_e$) du substrat.

9. Filtre selon l'une quelconque des revendications 1 à 8, caractérisé en ce que chaque inductance (16, 17, 18) d'un circuit bouchon a d'une part, une extrémité reliée à une plaque (19$_a$, 20$_a$, 21$_a$) ajourée de fenêtres formant la première armature du condensateur d'accord qui lui correspond et a, d'autre part, son autre extrémité reliée à la plaque enterrée (19$_b$, 20$_b$, 21$_b$) en vis à vis formant l'autre armature du condensateur d'accord, par l'intermédiaire d'une partie métallique (38, 39, 40) en saillie sur la plaque enterrée (19$_b$, 20$_b$, 21$_b$) dont l'extrémité vient crever la face du substrat supportant la plaque ajourée de fenêtres.

10. Filtre selon l'une quelconque des revendications 1 à 9, caractérisé en ce que les plaques des condensateurs sont déposées sur le substrat par sérigraphie.

**Claims**

1. A miniature microwave filter comprising resonators which are constituted by rejector circuits (1, 2, 3, 4, 5) and are coupled by capacitors (6, 7, 8, 9), the tuning capacitors and the coupling capacitors being composed of parallel metal plates supported and separated by the dielectric material (30) of a substrate, characterized in that the surface of at least one plate (19$_a$, 20$_a$, 44, 45, 46, 47) of each tuning capacitor and/or coupling capacitor (19, 20, 21 ; 22, 23, 24, 25, 26, 27, 28, 29) is provided with windows (41, 42, 43) which can be sealed-off by a metal deposit in order to allow each capacitor to be adjusted to its optimum value.

2. A filter according to claim 1, characterized in that the coupling between successive resonators is made by means of at least two capacitors (22, 23 ; 24, 25 ; 26, 27 ; 28, 29) connected in series, in order to permit accurate measurement of the value of each of the two capacitors by providing access to the common connection point (D, F, H, J) of the two capacitors.

3. A filter according to any one of claims 1 and 2, characterized in that the areas of the windows in one plate are all different.

4. A filter according to claim 3, characterized in that the areas of the windows in a plate are sized according to the set of weights of a balance in order to facilitate the precise adjustment of the capacitors (19, 20, 21, 22, 23, 24, 25, 26, 27, 28, 29).

5. A filter according to any one of claims 1 to 4, characterized in that metal studs (48, 49) are further disposed close to the plates ($10_b$, $11_a$, $13_b$, $14_a$) of the tuning capacitors in the input and output rejector circuits of the filter, in order to increase at will the surface of a plate situated close to the pads by respective values of the corresponding area elements of these pads.

6. A filter according to claim 5, characterized in that the area of a plate ($10_b$, $11_a$, $13_b$, $14_a$) is increased by the area element of a pad (48, 49) by connecting the plate to the pad via a metal deposit.

7. A filter according to any one of claims 1 to 6, characterized in that the plates ($19_a$, $20_a$, $21_a$) which are provided with windows are disposed in a surface ($30_b$) outside of the substrate and that the plates ($19_b$, $20_b$, $21_b$) which are opposed thereto in order to constitute the second plate of each corresponding capacitor are embedded in the thickness of the substrate.

8. A filter according to claim 7, characterized in that the plates which are provided with windows and which are disposed on one surface of the substrate are connected to a metal strip laid on the other surface of the substrate via a metal strip (38) laid on a longitudinal surface ($30_e$) of the substrate.

9. A filter according to any one of claims 1 to 8, characterized in that each inductance (16, 17, 18) of a rejector circuit is connected through one end to a plate ($19_a$, $20_a$, $21_a$) provided with windows and constituting the first plate of the tuning capacitor which corresponds thereto, whereas the other end of each inductance is connected to the embedded plate ($19_b$, $20_b$, $21_b$) opposed thereto and constituting the other plate of the tuning capacitor, via a metallic part (38, 39, 40) which projects beyond the embedded plate ($19_b$, $20_b$, $21_b$), the end of which emerges from the surface supporting the plate provided with windows.

10. A filter according to any one of claims 1 to 9, characterized in that the plates of the capacitors are deposited on the substrate by a serigraphic process.

**Patentansprüche**

1. Miniatur-Mikrowellenfilter mit als Sperrkreise (1, 2, 3, 4, 5) ausgebildeten Resonatoren, die über Kondensatoren (6, 7, 8, 9) gekoppelt sind, wobei die Abstimmungs- und Kopplungskondensatoren von parallelen Metallplatten gebildet werden, die durch das Dielektrikum (30) eines Substrats getragen und voneinander auf Abstand gehalten werden, dadurch gekennzeichnet, daß die Oberfläche mindestens einer der Platten ($19_a$, $20_a$, 44, 45, 46, 47) jedes Abstimmungs- und/oder Kopplungskondensators (19, 20, 21 ; 22, 23, 24, 25, 26, 27, 28, 29) mit Fenstern (41, 42, 43) versehen ist, die durch eine Metallbeschichtung verstopft werden können, wodurch sich die Einstellung jedes Kondensators auf seinen optimalen Wert erreichen läßt.

2. Filter nach Anspruch 1, dadurch gekennzeichnet, daß die Kopplung zwischen aufeinanderfolgenden Resonatoren durch mindestens zwei Kondensatoren (22, 23 ; 24, 25 ; 26, 27 ; 28, 29) erfolgt, die in Serie geschaltet sind, so daß es möglich ist, durch Zugang zum Verbindungspunkt (D, F, H, J) zwischen den beiden Kondensatoren jeden dieser Kondensatoren genau zu messen.

3. Filter nach einem beliebigen der Ansprüche 1 und 2, dadurch gekennzeichnet, daß die Fensterflächen auf einer Platte alle unterschiedliche Größen aufweisen.

4. Filter nach Anspruch 3, dadurch gekennzeichnet, daß die Flächen der Fenster auf einer Platte gemäß dem Gewichtesatz eines Waage proportioniert sind, um die genaue Einstellung der Kondensatoren (19, 20, 21, 22, 23, 24, 25, 26, 27, 28, 29) zu erleichtern.

5. Filter nach einem beliebigen der Ansprüche 1 bis 4, dadurch gekennzeichnet, daß außerdem Metallinseln (48, 49) in der Nähe der Platten ($10_b$, $11_a$, $13_b$, $14_a$) der Abstimmungskondensatoren in den Eingangs- und Ausgangssperrkreisen des Filters angeordnet sind, um nach Wunsch die Fläche einer in der Nähe der Inseln liegenden Platte um die jeweiligen Werte der diesen Inseln entsprechenden Oberflächenelemente vergrößern zu können.

6. Filter nach Anspruch 5, dadurch gekennzeichnet, daß die Vergrößerung der Oberfläche einer Platte ($10_b$, $11_a$, $13_b$, $14_a$) um das Oberflächenelement einer Insel (48, 49) dadurch geschieht, daß die Platte mit der Insel über eine Metallbeschichtung verbunden wird.

7. Filter nach einem beliebigen der Ansprüche 1 bis 6, dadurch gekennzeichnet, daß die mit den Fenstern versehenen Platten ($19_a$, $20_a$, $21_a$) außerhalb des Substrats angeordnet sind und daß die diesen gegenüberliegenden Gegenplatten ($19_b$, $20_b$, $21_b$) jedes entsprechenden Kondensators in die Dicke des Substrats eingebettet sind.

8. Filter nach Anspruch 7, dadurch gekennzeichnet, daß die mit den Fenstern versehenen Platten, die auf einer Seite des Substrats liegen, an ein metallisiertes Band angeschlossen sind, das die andere Seite des Substrats bedeckt, und zwar über ein metallisiertes Band (38), welches auf einer Längsseite ($30_e$) des Substrats liegt.

9. Filter nach einem beliebigen der Ansprüche 1 bis 8, dadurch gekennzeichnet, daß jede Induktivität (16, 17, 18) eines Sperrkreises mit einem Ende an eine mit Fenstern versehene Platte ($19_a$, $20_a$, $21_a$) angeschlossen ist, die den ersten Belag des ihm entsprechenden Abstimmungskondensators bildet, und mit dem anderen Ende an die gegenüberliegende eingebettete Platte ($19_b$, $20_b$, $21_b$) angeschlossen ist, die den anderen Belag des Abstimmungskondensators bildet, und zwar über einen über die eingebettete Platte ($19_b$, $20_b$, $21_b$) vorstehenden metallischen Bereich, dessen Ende über die die mit Fenstern versehene Platte tragende Substratseite hervorragt.

10. Filter nach einem beliebigen der Ansprüche 1 bis 9, dadurch gekennzeichnet, daß die Platten der Kondensatoren auf dem Substrat durch Seriegraphie aufgebracht sind.

Fig.1

Fig.2

Fig.3

Fig.4

Fig.5